# FASCICULE DE BREVET EUROPEEN

(11) **EP 3 239 670 B1**
(45) Date de publication et mention de la délivrance du brevet: **10.04.2019**
(21) Numéro de dépôt: 17167659.6
(22) Date de dépôt: 23.04.2017
(51) Int. Cl.: G01J 5/02, G01J 5/04, G01J 5/20

(54) **PROCEDE DE REALISATION D'UN DISPOSITIF DE DETECTION DE RAYONNEMENT ELECTROMAGNETIQUE COMPORTANT UNE COUCHE EN UN MATERIAU GETTER**
HERSTELLUNGSVERFAHREN EINER VORRICHTUNG ZUR ERFASSUNG VON ELEKTROMAGNETISCHER STRAHLUNG, DIE EINE SCHICHT AUS GETTERMATERIAL UMFASST
METHOD FOR PRODUCING A DEVICE FOR DETECTING ELECTROMAGNETIC RADIATION HAVING A LAYER OF GETTER MATERIAL

(30) Priorité: 28.04.2016 FR 1653764
(43) Date de publication de la demande: 01.11.2017
(73) Titulaire: COMMISSARIAT À L'ÉNERGIE ATOMIQUE ET AUX ÉNERGIES ALTERNATIVES, 75015 Paris (FR)
(72) Inventeur: YON, Jean-Jacques, 38360 SASSENAGE (FR)
(74) Mandataire: GIE Innovation Competence Group

(56) Documents cités:
- EP-A1- 2 743 659
- US-A1- 2016 023 888
- US-A1- 2016 097 681

## Description

### DOMAINE TECHNIQUE

Le domaine de l'invention est celui des dispositifs de détection de rayonnement électromagnétique, en particulier infrarouge ou térahertz, comportant au moins un détecteur thermique encapsulé dans une cavité hermétique, une couche mince d'un matériau getter étant située dans la cavité hermétique. L'invention s'applique notamment au domaine de l'imagerie infrarouge et de la thermographie.

### ÉTAT DE LA TECHNIQUE ANTÉRIEURE

Un dispositif de détection de rayonnement électromagnétique, par exemple infrarouge ou térahertz, peut comprendre une matrice de détecteurs thermiques, dits élémentaires, chaque détecteur comportant une portion absorbante apte à absorber le rayonnement électromagnétique à détecter.

Dans le but d'assurer l'isolation thermique des détecteurs thermiques, les portions absorbantes se présentent habituellement sous la forme de membranes suspendues au-dessus du substrat par des piliers d'ancrage, et sont isolées thermiquement de celui-ci par des bras de maintien et d'isolation thermique. Ces piliers d'ancrage et bras d'isolation présentent également une fonction électrique en reliant électriquement les membranes suspendues à un circuit de lecture généralement disposé dans le substrat.

Le circuit de lecture se présente habituellement sous la forme d'un circuit CMOS. Il permet l'application d'un signal de commande aux détecteurs thermiques ainsi que la lecture de signaux de détection générés par les détecteurs thermiques en réponse à l'absorption du rayonnement électromagnétique à détecter. Le circuit de lecture comporte différents niveaux d'interconnexion électrique formés de lignes métalliques séparées les unes des autres par des couches diélectriques dites inter-métal. Un plot de connexion électrique du circuit de lecture est disposé sur le substrat de telle manière qu'il puisse être contacté depuis l'extérieur du dispositif de détection.

Le document EP2743659 décrit ainsi deux exemples de dispositif de détection d'un rayonnement infrarouge, dont le procédé de réalisation utilise des couches sacrificielles minérales identiques ou similaires aux couches diélectriques inter-métal du circuit de lecture.

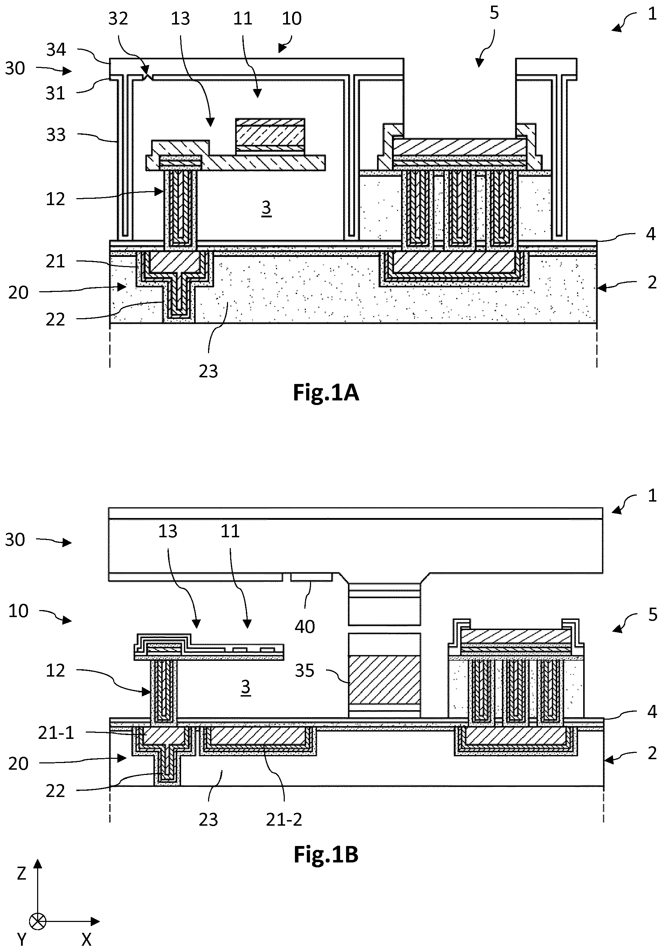

La figure 1A illustre un premier exemple de dispositif de détection 1 qui comporte une pluralité de détecteurs thermiques 10 comportant chacun une membrane absorbante 11 suspendue au-dessus du substrat 2 et reliée électriquement à une portion 21 de ligne métallique du circuit de lecture CMOS 20, la ligne métallique appartenant ici à un avant-dernier niveau d'interconnexion électrique du circuit CMOS 20. Les détecteurs thermiques 10 sont réalisés en utilisant des couches sacrificielles en un matériau minéral identique ou similaire à celui des couches diélectriques inter-métal 23 du circuit CMOS 20. Un plot de connexion électrique 5 est agencé de manière à pouvoir connecter le circuit CMOS 20 depuis d'extérieur du dispositif de détection 1. Une couche d'arrêt de gravure 4 s'étend continûment sur la surface du substrat 2, de manière à bloquer la progression d'une gravure chimique mise en oeuvre lors de l'étape de suppression des couches sacrificielles minérales et ainsi préserver le circuit CMOS 20. Le ou les détecteurs thermiques 10 sont encapsulés dans une cavité hermétique 3 en partie délimitée par une couche d'encapsulation 31 recouverte d'une couche de scellement 34, cette dernière assurant notamment l'obturation d'au moins un évent de libération 32 permettant l'évacuation des produits de gravure lors de l'étape de suppression des couches sacrificielles minérales.

La figure 1B illustre un deuxième exemple de dispositif de détection 1, dont les détecteurs thermiques 10 sont également réalisés en utilisant des couches sacrificielles minérales. Une couche d'arrêt de gravure 4 assure également la protection des couches diélectriques inter-métal 23 du circuit CMOS 20 lors de l'étape de suppression des couches sacrificielles minérales. Une deuxième portion 21-2 de la même ligne métallique que celle de la portion 21-1, située en regard de la membrane absorbante 11 et recouverte par la couche d'arrêt de gravure 4, assure une fonction de réflexion optique des longueurs d'onde à détecter. Le ou les détecteurs thermiques 10 sont encapsulés dans une cavité hermétique 3 formée ici par une structure d'encapsulation 30 qui prend la forme ici d'un capot rapporté, assemblé au substrat 2 au moyen d'un joint hermétique 35. Une couche 40 comportant un matériau getter est située sur une surface inférieure du capot rapporté 30, dans le but d'assurer le pompage gazeux à l'intérieur de la cavité hermétique 3.

Cependant, il existe un besoin de disposer d'un procédé de réalisation d'un dispositif de détection d'un rayonnement électromagnétique, qui comporte l'utilisation d'au moins une couche sacrificielle minérale, et dont une couche en un matériau getter soit déposée sur la surface du substrat, à l'intérieur de la cavité hermétique.

Il existe également un besoin de disposer d'un tel procédé de réalisation d'un dispositif de détection d'un rayonnement électromagnétique qui autorise la formation d'une couche mince d'encapsulation s'étendant au-dessus et autour du ou des détecteurs thermiques.

Il existe également un besoin de disposer d'un tel procédé qui permette la réalisation d'un dispositif de détection d'un rayonnement électromagnétique dont la sensibilité de détection est améliorée.

Le document US2016/0097681 décrit un procédé de réalisation d'un dispositif de détection sur un substrat en verre. Une couche métallique getter est déposée sur le substrat, puis est recouverte par une couche sacrificielle. Un détecteur thermique est réalisé de sorte que la membrane absorbante repose sur la couche sacrificielle.

Le document US2016/0023888 porte sur la problématique d'encapsulation par couches minces. Il décrit en particulier la réalisation de cavités par suppression de couches sacrificielles. Une couche getter peut être présente dans les cavités. Elle peut être recouverte par une couche de protection.

### EXPOSÉ DE L'INVENTION

L'invention a pour objectif de remédier au moins en partie aux inconvénients de l'art antérieur, et plus particulièrement de proposer un procédé de réalisation d'un dispositif de détection de rayonnement électromagnétique comprenant au moins un détecteur thermique, celui-ci comportant une membrane absorbante adaptée à absorber le rayonnement à détecter, suspendue au-dessus d'un substrat, le détecteur thermique étant destiné à être situé dans une cavité hermétique. Le procédé comportant au moins les étapes suivantes :
- dépôt, sur le substrat, d'une couche métallique dite getter comprenant un matériau métallique à effet getter ;
- dépôt, de manière à recouvrir la couche métallique getter, d'une couche sacrificielle dite carbonée comprenant un matériau carboné en carbone amorphe apte à être gravé sélectivement vis-à-vis de la couche métallique getter par une seconde gravure chimique ;
- dépôt, sur la couche sacrificielle carbonée, d'au moins une couche sacrificielle minérale comprenant un matériau minéral apte à être gravé sélectivement vis-à-vis de la couche sacrificielle carbonée par une première gravure chimique ;
- aplanissement mécano-chimique de la couche sacrificielle minérale ;
- réalisation du détecteur thermique de sorte que la membrane absorbante est réalisée sur la couche sacrificielle minérale ;
- suppression de la couche sacrificielle minérale par ladite première gravure chimique ;

Certains aspects préférés, mais non limitatifs de ce dispositif de détection sont les suivants.

Le matériau métallique à effet getter peut être choisi parmi le titane, le zirconium, le vanadium, le chrome, le cobalt, le fer, le manganèse, le palladium, le baryum, et/ou l'aluminium.

Le matériau minéral peut être un matériau comportant au moins de l'oxyde de silicium ou du nitrure de silicium.

La première gravure chimique peut être une attaque chimique en milieu acide, de préférence à l'acide fluorhydrique en phase vapeur.

La seconde gravure chimique peut être une gravure sèche par plasma d'oxygène.

La couche métallique getter peut reposer et être au contact d'une couche électriquement isolante du substrat, ou peut reposer et être au contact d'une couche d'arrêt de gravure réalisée en un matériau apte à stopper la première gravure chimique et recouvrant une face supérieure du substrat.

La couche sacrificielle carbonée peut recouvrir la couche métallique getter.

La couche métallique getter peut comporter plusieurs portions distinctes, dont au moins une première portion est située sous la membrane absorbante.

L'étape de réalisation du détecteur thermique peut comporter la formation d'une structure d'encapsulation dudit détecteur thermique, la structure d'encapsulation comportant une couche d'encapsulation s'étendant autour et au-dessus dudit détecteur thermique de manière à définir avec le substrat la cavité hermétique dans laquelle ledit détecteur thermique est situé, la couche d'encapsulation comprenant au moins un orifice traversant, dit évent de libération. Des matériaux supprimés lors des première et deuxième gravures chimiques peuvent être évacués au travers dudit évent de libération.

La couche d'encapsulation peut être formée en au moins un matériau comportant du silicium.

La couche d'encapsulation peut comporter une paroi périphérique qui s'étend autour dudit détecteur thermique, et qui est au contact de la couche métallique getter.

Le détecteur thermique peut comporter au moins un pilier d'ancrage assurant le maintien de la membrane absorbante au-dessus du substrat, le pilier d'ancrage étant au contact de la couche métallique getter.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés, outre les figures 1A et 1B déjà décrites, sur lesquels :
les figures 2A à 2H sont des vues schématiques en coupe de différentes étapes d'un procédé de réalisation d'un dispositif de détection selon un premier mode de réalisation ;
la figure 3 est une vue schématique en coupe d'un dispositif de détection selon un deuxième mode de réalisation ;
la figure 4 est une vue schématique en coupe d'un dispositif de détection selon un troisième mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près.

L'invention porte sur la réalisation d'un dispositif de détection de rayonnement électromagnétique 1 adapté à détecter un rayonnement infrarouge ou térahertz. Il comporte au moins un détecteur thermique 10 destiné à être situé dans une cavité hermétique 3, et une couche 40 comportant un matériau à effet getter présente sur le substrat 2 à l'intérieur de la cavité hermétique 3. Ce matériau à effet getter, également appelé matériau getter, est un matériau exposé à l'atmosphère de la cavité hermétique 3, et apte à réaliser un pompage gazeux par absorption et/ou adsorption.

Ce matériau getter est un matériau métallique qui peut être choisi parmi le titane, le zirconium, le vanadium, le chrome, le cobalt, le fer, le manganèse, le palladium, le baryum et/ou l'aluminium, voire un alliage de ces métaux tel que le TiZrV. Comme mentionné plus loin, la couche métallique getter 40 peut également être réflectrice aux longueurs d'onde à détecter, voire peut être utilisée pour améliorer l'accroche de certains éléments du dispositif de détection 1 au substrat 2.

L'invention porte également sur le dépôt puis la gravure d'une couche sacrificielle 50 dite de protection, apte à protéger la couche métallique getter 40 lors d'une étape de gravure chimique mise en oeuvre ultérieurement pour supprimer une couche sacrificielle minérale 60A, 60B, telle qu'une attaque chimique en milieu acide, par exemple à l'acide fluorhydrique en phase vapeur.

Cette couche sacrificielle de protection 50 comporte un matériau carboné, c'est-à-dire un matériau formé d'au moins un type d'espèce chimique comportant des atomes de carbones. Il peut ainsi s'agir d'un matériau minéral tel que du carbone amorphe, éventuellement de type DLC (pour *Diamond Like Carbon,* en anglais), ou un matériau organique tel que du polyimide. Le carbone de type DLC est du carbone amorphe à fort taux d'hybridation en carbone sp³. De préférence, le matériau carboné ne comporte pas de silicium, de manière à éviter la présence d'éventuels résidus à la suite de l'étape de gravure de cette couche 50.

La couche sacrificielle carbonée 50 comportant, ou constituée d'un tel matériau, est ainsi sensiblement inerte vis-à-vis de la gravure chimique effectuée ultérieurement pour supprimer la couche sacrificielle minérale 60A, 60B. Par sensiblement inerte, on entend que le matériau carboné ne réagit sensiblement pas avec le milieu acide utilisé lors de cette étape de gravure, voire réagit peu de sorte que la couche sacrificielle carbonée 50 n'est pas gravée sur toute son épaisseur à l'issue de cette étape de gravure, la couche métallique getter 40 restant ainsi préservée de toute dégradation par la couche sacrificielle carbonée 50.

La couche sacrificielle carbonée 50 peut en outre être supprimée par une gravure chimique telle qu'une gravure chimique sèche dont un agent de gravure est de l'oxygène contenu dans un plasma.

L'invention porte également sur le dépôt puis la gravure d'au moins une couche sacrificielle 60A, 60B comportant un matériau minéral, ou inorganique, dite couche sacrificielle minérale.

Le matériau minéral est ici un matériau diélectrique à base de silicium permettant la réalisation d'une couche diélectrique inter-métal 23 du circuit de lecture 20, c'est-à-dire un matériau isolant électrique, avec par exemple une constante diélectrique, ou permittivité relative, inférieure ou égale à 3,9, permettant de limiter la capacité parasite entre les interconnexions. Il s'agit d'un matériau ne comportant pas de chaînes carbonées, tel qu'un oxyde de silicium SiOx ou un nitrure de silicium SiₓN_{y}, voire un matériau organosilicié tel que du SiOC, du SiOCH, ou d'un matériau de type verre fluoré tel que du SiOF.

Une couche sacrificielle minérale 60A, 60B comportant, ou constituée d'un tel matériau, peut être supprimée par une gravure chimique humide telle qu'une attaque chimique en milieu acide, par exemple à l'acide fluorhydrique en phase vapeur. Par gravure humide, on entend d'une manière générale que l'agent de gravure se présente en phase liquide ou en phase vapeur, et, dans le cadre de l'invention, en phase vapeur.

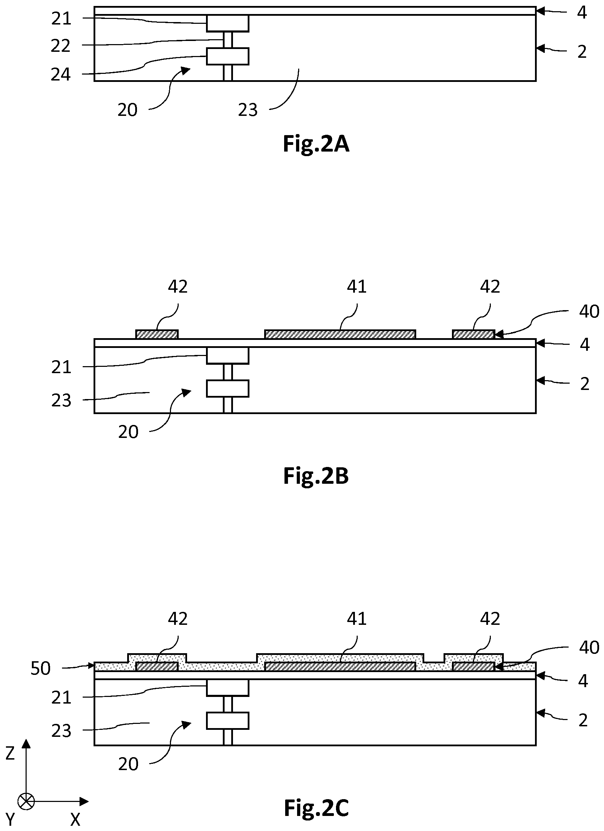

Les figures 2A à 2G illustrent différentes étapes de réalisation d'un dispositif de détection 1 selon un premier mode de réalisation. Plusieurs étapes, hormis les étapes de dépôt du matériau getter, de dépôt et de suppression de la couche sacrificielle carbonée 50, peuvent être similaires ou identiques à celles du procédé décrit dans le document EP2743659.

On définit ici et pour la suite de la description un repère direct tridimensionnel (X,Y,Z), où le plan (X,Y) est sensiblement parallèle au plan d'un substrat 2 du dispositif de détection 1, l'axe Z étant orienté suivant une direction sensiblement orthogonale au plan du substrat 2. Les termes « vertical » et « verticalement » s'étendent comme étant relatifs à une orientation sensiblement parallèle à l'axe Z, et les termes « horizontal » et « horizontalement » comme étant relatifs à une orientation sensiblement parallèle au plan (X,Y). Par ailleurs, les termes « inférieur » et « supérieur » s'étendent comme étant relatifs à un positionnement croissant lorsqu'on s'éloigne du substrat 2 suivant la direction +Z.

En référence à la figure 2A, on réalise un substrat 2 comportant un circuit de lecture 20 de type circuit CMOS. Le circuit CMOS 20 est apte à alimenter et mesurer le signal délivré par les détecteurs thermiques 10. Il comporte ainsi des éléments électroniques actifs, tels que des diodes, transistors, condensateurs, résistances..., connectés électriquement par des interconnections métalliques aux détecteurs thermiques 10, ainsi qu'à un plot de connexion (non représenté) destiné à relier électriquement le dispositif de détection 1 à un dispositif électronique externe. Le circuit de lecture 20 comporte ici un niveau d'interconnexion électrique comportant une première portion 21 d'une ligne métallique, électriquement reliée à une portion 24 de ligne métallique d'un niveau inférieur d'interconnexion électrique par un via conducteur 22. Les vias 22 et lignes métalliques sont séparés les uns des autres par des couches diélectriques inter-métal 23. Le substrat 2 comporte ici une face supérieure au niveau de laquelle affleurent la portion 21 de ligne métallique ainsi que la couche diélectrique inter-métal 23. Cette étape de réalisation du substrat 2 peut être identique ou similaire à celle décrite dans le document EP2743659. Ainsi, à titre illustratif, les vias conducteurs 22 et les portions 21, 24 de lignes métalliques peuvent être réalisés en cuivre, en aluminium ou en tungstène, par un procédé damascène dans lequel on remplit avec du cuivre des tranchées réalisées dans la couche diélectrique inter-métal 23. Le cuivre ou le tungstène peut éventuellement être intercalé transversalement entre des couches verticales en nitrure de titane, de tantale ou autre. L'affleurement de la portion de ligne métallique au niveau de la face supérieure de la couche diélectrique inter-métal 23 peut être obtenu par une technique de polissage mécano-chimique (CMP).

On dépose, sur au moins une partie de la face supérieure du substrat 2, une couche d'arrêt de gravure 4. Celle-ci recouvre ainsi continûment la couche diélectrique inter-métal 23 et la portion 21 de ligne métallique qui forment ensemble la face supérieure du substrat 2. La couche d'arrêt de gravure 4 comporte un matériau sensiblement inerte à une gravure chimique mise en oeuvre ultérieurement pour supprimer une couche sacrificielle carbonée 50, plus précisément une gravure chimique sèche à plasma d'oxygène. Ce matériau peut en outre être sensiblement inerte à une gravure chimique mise en oeuvre ultérieurement pour supprimer la ou les couches sacrificielles minérales 60A, 60B, plus précisément une attaque chimique en milieu HF en phase vapeur, dans le cas où la couche sacrificielle carbonée 50 ne recouvrirait pas entièrement la face supérieure du substrat 2. La couche d'arrêt de gravure 4 permet ainsi d'éviter que les couches diélectriques inter-métal 23 du circuit CMOS 20 ne soient gravées lors des étapes de suppression des couches sacrificielles. Elle peut être formée d'alumine Al₂O₃, voire de nitrure d'aluminium, de trifluorure d'aluminium, ou de silicium amorphe non intentionnellement dopé. Elle peut être déposée par exemple par ALD (pour *Atomic Layer Deposition,* en anglais) et présenter une épaisseur par exemple de l'ordre d'une dizaine de nanomètres à quelques centaines de nanomètres, par exemple une épaisseur comprise entre 20nm et 150nm.

En référence à la figure 2B, on dépose ensuite, sur la couche d'arrêt de gravure 4, une couche métallique getter 40. Cette couche comporte un matériau métallique adapté à assurer un effet getter, c'est-à-dire à pomper, par absorption et/ou adsorption, les molécules de gaz présentes dans la cavité hermétique 3. Cet effet getter permet d'améliorer ou de maintenir un niveau de vide requis dans la cavité hermétique 3. Ce matériau est en outre sensiblement inerte à une gravure chimique effectuée ultérieurement pour supprimer la couche sacrificielle carbonée 50, plus précisément ici une gravure chimique sèche par plasma d'oxygène. Le matériau métallique est à base de titane, de zirconium, de vanadium, de chrome, de cobalt, de fer, de manganèse, de palladium, et/ou d'aluminium, c'est-à-dire qu'il comporte l'un de ces métaux ou un alliage de ces métaux, tel que le TiZrV. Parmi ces métaux, le titane, le zirconium, le palladium et le vanadium, et leurs alliages, présentent des propriétés élevées de chimisorption (effet getter). Le matériau peut être déposé par les techniques standards de la microélectronique, par exemple par pulvérisation cathodique, par évaporation sous vide ou par dépôt chimique en phase valeur. La couche métallique getter 40 peut présenter une épaisseur de l'ordre de quelques dizaines de nanomètres à quelques centaines de nanomètres, par exemple une épaisseur comprise entre 50nm et 500nm, voire comprise entre 100nm et 300nm.

La couche métallique getter 40 peut être constituée d'un même matériau ou de plusieurs matériaux parmi les matériaux susmentionnés. Elle peut ainsi être formée d'un empilement de plusieurs couches dites élémentaires, par exemple une couche inférieure de 50nm de titane, une couche intermédiaire de 100nm d'aluminium et une couche supérieure de 200nm de titane.

La couche métallique getter 40 étant réalisée en un ou plusieurs desdits matériaux métalliques, elle peut également assurer, lorsqu'elle est située en regard de la membrane absorbante 11, une fonction de réflexion optique des longueurs d'onde destinées à être détectées, améliorant ainsi la sensibilité du détecteur thermique 10.

La couche métallique getter 40 peut en outre assurer une fonction supplémentaire d'accroche permettant d'améliorer l'adhérence d'éléments du dispositif de détection 1 sur le substrat 2. Le titane et le chrome présentent ainsi, parmi la liste des matériaux susmentionnés, des propriétés d'adhérence élevées.

La couche métallique getter 40 s'étend ici de manière discontinue et comportent des portions distinctes les unes des autres, obtenues par des opérations classiques de photolithographie et de gravure.

Ainsi, une première portion 41 présente une surface importante, par exemple de l'ordre du pixel, éventuellement en forme de rectangle ou de carré, favorisant la fonction getter de piégeage chimique de molécules de gaz. La première portion 41 s'étend avantageusement sous la membrane absorbante 11 de manière à former une cavité interférentielle quart d'onde avec cette dernière, améliorant la sensibilité du détecteur thermique 10.

Une deuxième portion 42 peut avantageusement être réalisée dans une zone où sera réalisé un élément du dispositif de détection 1 dont l'adhérence au substrat 2 sera ainsi renforcée par la qualité d'accroche qu'offre la couche métallique getter 40. Elle peut ainsi être située en bordure de la cavité 3, de manière à recevoir la paroi périphérique 33 de la couche d'encapsulation 31 qui sera ultérieurement réalisée.

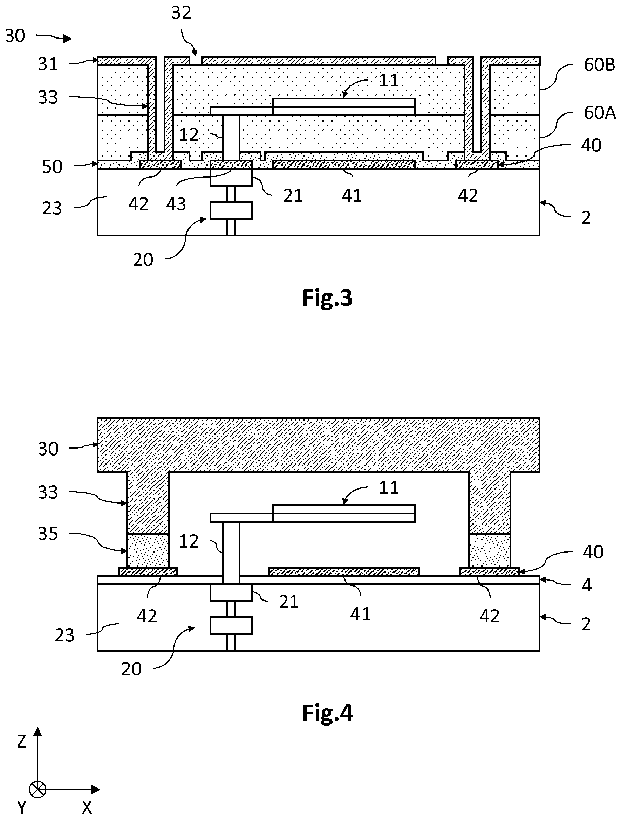

Une troisième portion (non représentée) peut avantageusement être réalisée au niveau de la portion 21 de la ligne métallique et dans une zone où sera réalisé le pilier d'ancrage 12 du détecteur thermique 10. Le pilier d'ancrage 12 pourra ainsi être au contact de la troisième portion de couche métallique getter 40, cette dernière étant de préférence directement au contact de la portion 21 de ligne métallique. On améliore ainsi la qualité du contact électrique entre le circuit de lecture CMOS 20 et le pilier d'ancrage 12, ainsi que l'accroche du pilier d'ancrage sur le substrat. Cette troisième portion est particulièrement avantageuse lorsque la couche d'arrêt de gravure 4 n'est pas présente, comme décrit plus loin en référence à la figure 3.

En référence à la figure 2C, on dépose ensuite une couche sacrificielle de protection, dite couche sacrificielle carbonée 50, de manière à recouvrir entièrement la couche métallique getter 40. Ainsi, cette dernière ne comporte pas de surface libre, c'est-à-dire une surface accessible à un agent de gravure.

La couche sacrificielle carbonée 50 comporte un matériau carboné apte à être gravé sélectivement vis-à-vis de la couche métallique getter 40, c'est-à-dire qu'il peut être supprimé lors d'une étape de gravure chimique mise en oeuvre ultérieurement, plus précisément ici une gravure chimique sèche par plasma d'oxygène, sans que la couche métallique getter 40 ne soit dégradée par cette même gravure chimique. Il est en outre sensiblement inerte vis-à-vis d'une autre gravure chimique effectuée ultérieurement pour supprimer des couches sacrificielles minérales 60A, 60B, telle qu'une attaque chimique en milieu acide, par exemple à l'acide fluorhydrique en phase vapeur.

Le matériau carboné, c'est-à-dire un matériau comportant des atomes de carbone, est choisi parmi le carbone amorphe, éventuellement de type DLC. Dans une variante de la présente invention, on peut également utiliser le polyimide. Dans le cas du carbone de type DLC, la couche sacrificielle carbonée 50 peut présenter une résistivité électrique de l'ordre de 10⁶Ω.cm, ce qui est avantageux pour éviter le couplage électrique parasite entre deux piliers d'ancrage 12 d'un même détecteur thermique 10, lorsqu'ils sont portés à des potentiels électriques différents lors d'une phase de test électrique, ces piliers d'ancrage 12 étant en contact avec la même couche sacrificielle carbonée 50. En variante (non représentée), il est possible d'effectuer une gravure localisée de la couche sacrificielle carbonée 50 pour éviter tout couplage électrique parasite entre les piliers d'ancrage 12 d'un même détecteur thermique 10 via cette couche sacrificielle carbonée 50.

Le matériau carboné, c'est-à-dire le carbone amorphe, peut être déposé en couche mince par une technique de dépôt conforme, tel que le dépôt chimique en phase vapeur assistée par plasma (PECVD, pour *Plasma Enhanced Chemical Vapor Deposition,* en anglais), ou le dépôt physique en phase vapeur (PVD, pour *Physical Vapor Deposition,* en anglais) par exemple via la pulvérisation d'une cible carbone par faisceau d'ions (IBS). Dans le cas du polyimide, il peut être déposé par dispense puis centrifugation (*spin coating*)*.*

La couche sacrificielle carbonée 50 présente une épaisseur comprise entre quelques dizaines de nanomètres à quelques centaines de nanomètres, par exemple comprise entre 50 nm et 500nm, voire comprise entre 100 nm et 300 nm, de manière à obtenir un bon recouvrement des flancs des portions 41, 42 de matériau getter.

Le matériau carboné est ainsi inerte vis-à-vis d'un agent de gravure utilisé lors de la gravure chimique effectuée ultérieurement pour supprimer les couches sacrificielles minérales 60A, 60B, en particulier l'acide fluorhydrique en phase vapeur. C'est le cas notamment du carbone amorphe qui ne réagit sensiblement pas avec cet agent de gravure. C'est le cas également du polyimide qui réagit peu avec l'acide fluorhydrique, de sorte qu'il n'est pas supprimé sur toute son épaisseur à l'issue de cette étape de gravure chimique humide, la couche métallique getter 40 restant ainsi entièrement recouverte par une épaisseur non nulle de la couche sacrificielle carbonée 50.

Le matériau carboné est cependant apte à réagir vis-à-vis d'un agent de gravure utilisé lors de la gravure chimique effectuée ultérieurement pour supprimer cette couche sacrificielle carbonée 50, en particulier vis-à-vis d'oxygène présent dans un plasma d'une gravure chimique sèche.

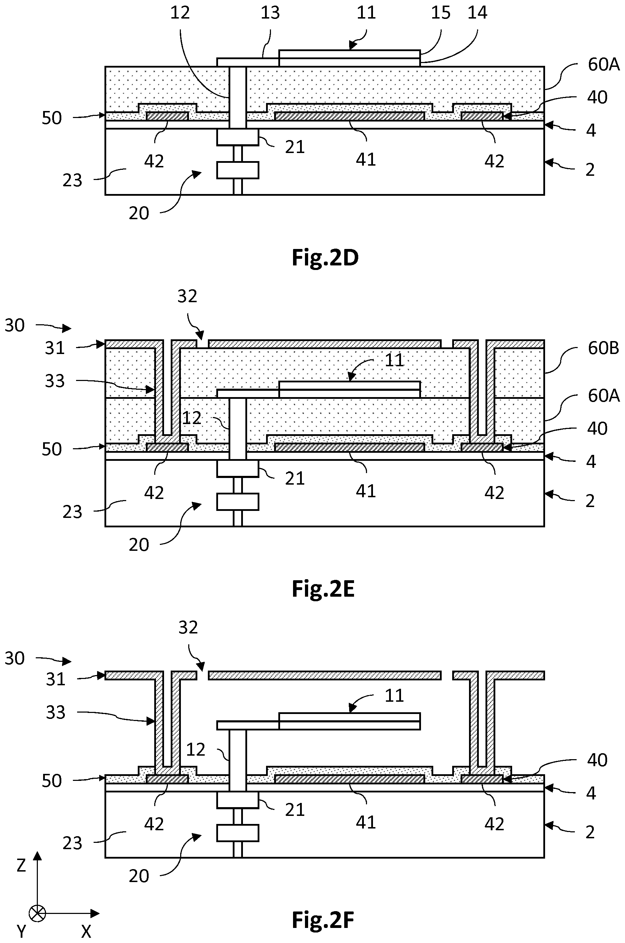

En référence à la figure 2D, on dépose ensuite une première couche sacrificielle dite minérale comprenant un matériau minéral, par exemple un oxyde de silicium SiOₓ déposé par PECVD. Ce matériau minéral est apte à être supprimé par gravure chimique humide, en particulier par attaque chimique en milieu acide, l'agent de gravure étant de préférence de l'acide fluorhydrique en phase vapeur. Cette couche sacrificielle minérale 60A est déposée de manière à s'étendre continûment sur sensiblement toute la surface du substrat 2 et recouvrir la couche sacrificielle carbonée 50. Elle présente une épaisseur, suivant l'axe Z, qui définit ultérieurement la distance séparant la membrane absorbante 11 du substrat 2. Cette épaisseur est ajustée en fonction des propriétés d'absorption du détecteur thermique 10 que l'on souhaite obtenir, et peut être comprise entre 1µm et 5µm pour la détection de rayonnement infrarouge, par exemple elle peut être égale à 2µm environ.

On réalise ensuite des orifices verticaux destinés à la formation des piliers d'ancrage 12 du détecteur thermique 10. Ils sont réalisés par photolithographie et gravure, et traversent la première couche sacrificielle minérale 60A ainsi que la couche sacrificielle carbonée 50 ainsi que la couche d'arrêt de gravure 4, pour déboucher sur la portion 21 de ligne métallique. Les orifices verticaux peuvent présenter une section droite dans le plan (X,Y) de forme carrée, rectangulaire, ou circulaire, d'une surface sensiblement égale par exemple à 0,25µm².

On réalise ensuite les piliers d'ancrage 12 dans les orifices verticaux. Ils peuvent être réalisés par remplissage des orifices par un ou plusieurs matériaux électriquement conducteurs. A titre d'exemple, ils peuvent comporter chacun une couche de TiN déposée par MOCVD (pour *Metal Organic Chemical Vapor Deposition,* en anglais) sur les flancs verticaux des orifices, et un coeur en cuivre ou en tungstène remplissant l'espace délimité transversalement par la couche de TiN. Une étape de CMP, c'est-à-dire d'aplanissement mécano-chimique, permet ensuite de planariser la surface supérieure formée par la couche sacrificielle minérale 60A et par les piliers d'ancrage 12.

Les inventeurs ont constaté que la tenue mécanique de la couche sacrificielle minérale 60A lors de l'étape d'aplanissement mécano-chimique est améliorée lorsque cette dernière repose sur la couche de protection 50 en carbone amorphe. En effet, lorsque la couche de protection 50 est en polyimide, l'étape d'aplanissement mécano-chimique peut conduire à un décollement de la couche sacrificielle minérale 60A, notamment du fait de l'action mécanique de la tête de polissage sur la couche 60A. Les risques qu'un tel décollement ait lieu lors de l'étape de CMP sont diminués lorsque la couche de protection 50 est en carbone amorphe, en particulier lorsque la couche sacrificielle minérale 60A est réalisée en un oxyde de silicium SiOₓ.

On réalise ensuite la membrane absorbante 11 ainsi que le bras 13 de maintien et d'isolation thermique. Cette étape peut être effectuée de manière identique ou similaire à celle décrite dans le document EP2743659 et n'est pas reprise en détail. Ainsi, la membrane absorbante 11 peut comporter un matériau 15 adapté à absorber le rayonnement électromagnétique d'intérêt et un matériau thermistance 14 dont la conductivité électrique varie en fonction de l'échauffement de la membrane absorbante 11. Les matériaux choisis pour réaliser la membrane absorbante 11 et le bras d'isolation thermique 13 peuvent être choisis, entre autres, parmi le silicium amorphe, le nitrure de titane, l'aluminium, l'alumine, le nitrure d'aluminium, dans la mesure où ils sont sensiblement inertes à la gravure chimique humide effectuée ultérieurement pour supprimer les couches sacrificielles minérales 60A, 60B. La membrane absorbante 11 est positionnée de manière à être en regard de la première portion réflectrice 41 de la couche métallique getter 40.

En référence à la figure 2E, on réalise la structure d'encapsulation 30 de manière identique ou similaire à celle décrite dans le document EP2743659. Pour cela, on dépose une deuxième couche sacrificielle minérale 60B sur la première couche sacrificielle minérale 60A, les piliers d'ancrage 12 et les bras d'isolation thermique 13, ainsi que sur la membrane absorbante 11. Elle peut être réalisée dans le même matériau que celui de la première couche sacrificielle minérale 60A et présente une épaisseur par exemple comprise entre 0,5µm et 5µm.

On réalise ensuite des tranchées au travers de toute l'épaisseur des couches sacrificielles minérales 60A, 60B et de la couche sacrificielle carbonée 50 de manière à déboucher, dans ce mode de réalisation, sur les deuxièmes portions d'accroche 42 de la couche métallique getter 40. Ces tranchées peuvent être réalisée par des étapes de photolithographie et de gravure, par exemple de gravure RIE. Elles peuvent être réalisées de manière à s'étendre de manière continue autour d'un ou plusieurs détecteurs thermiques 10 dans le plan (X,Y), selon que la cavité 3 loge un ou plusieurs pixels comportant chacun un détecteur thermique 10. Elles sont destinées à la réalisation ultérieure de la paroi périphérique 33 de la structure d'encapsulation 30. Les portions d'accroche 42 de la couche métallique getter 40 forment ici des portions d'arrêt de gravure lors de la formation de ces tranchées.

On dépose ensuite une couche mince d'encapsulation 31, transparente au rayonnement à détecter, par une technique de dépôt conforme adaptée pour obtenir un bon recouvrement des flancs verticaux des tranchées, avec une épaisseur de couche sensiblement constante. Il peut s'agir par exemple d'une couche de silicium amorphe élaboré par CVD ou par iPVD, d'une épaisseur typiquement comprise entre environ 200nm et 2000nm lorsqu'elle est mesurée sur une surface plane, et de préférence de l'ordre de 750nm de manière à former une lame quart d'onde vis-à-vis d'une longueur d'onde de référence de 10µm lorsque le domaine spectral de détection du détecteur thermique est le LWIR (8µm à 14µm), améliorant ainsi la transmission du rayonnement incident au travers de cette couche 31. Le dépôt de la couche d'encapsulation 31 sur une surface structurée par des tranchées dont au moins une tranchée périphérique continue (périmètre fermé) conduit à la formation de la capsule, réalisée avec le matériau de la couche d'encapsulation 31, formant, avec le substrat 2, une cavité 3 dans laquelle sont logés un ou plusieurs détecteurs thermiques 10.

Des orifices traversants 32, formant des évents de libération destinés à permettre l'évacuation des couches sacrificielles 60A, 60B, 50 hors de la cavité 3, sont ensuite réalisés par photolithographie et gravure dans la couche d'encapsulation 31. Chaque évent 32 peut être de forme carrée, rectangulaire, circulaire, voire oblongue. A titre d'exemple, les évents 32 peuvent présenter une forme oblongue dont la longueur peut être de l'ordre de quelques microns, par exemple 5µm, et la largeur peut être de l'ordre d'une centaine à quelques centaines de nanomètres, par exemple être comprise entre 150nm et 600nm.

En référence à la figure 2F, on effectue une première gravure chimique adaptée à supprimer les deux couches sacrificielles minérales 60A, 60B, ici par une gravure chimique humide par attaque à l'acide fluorhydrique en phase vapeur, et former ainsi la cavité 3 logeant le ou les détecteurs thermiques 10. Les produits de la réaction chimique sont évacués au travers des évents de libération 32. Cette gravure chimique humide étant isotrope, on obtient la suspension de la membrane absorbante 11, et on libère les piliers d'ancrage 12 ainsi que la surface supérieure de la couche sacrificielle carbonée 50. La gravure par attaque HF vapeur est sélective de sorte que la couche sacrificielle carbonée 50 n'est pas supprimée, la couche métallique getter 40 étant alors entièrement protégée de l'attaque HF vapeur.

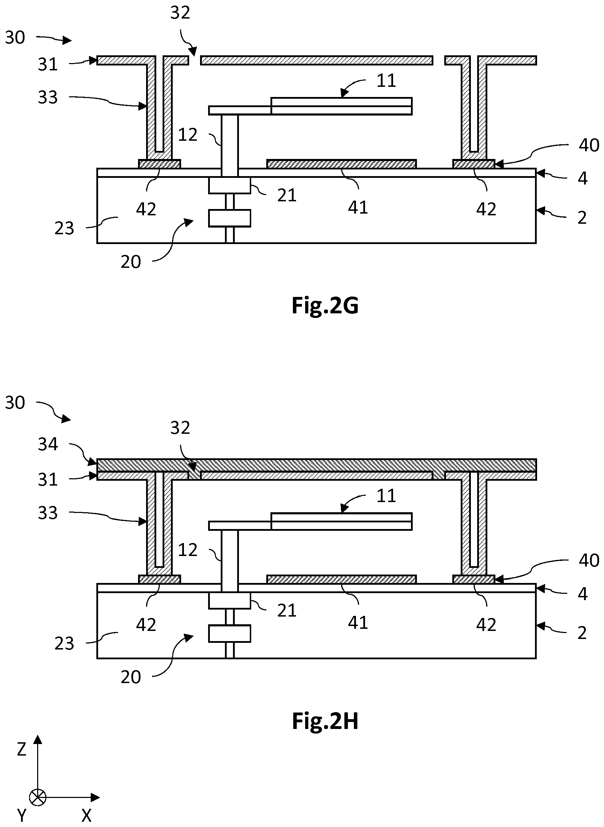

En référence à la figure 2G, on effectue une deuxième gravure chimique adaptée à supprimer la couche sacrificielle carbonée 50 et rendre libre la surface supérieure de la couche métallique getter 40. La gravure chimique est ici une gravure chimique sèche dont l'agent de gravure est de l'oxygène présent dans un plasma. Cette gravure chimique sèche étant isotrope, on préserve l'intégrité des structures libérées tout en facilitant l'accès à l'agent de gravure dans la cavité 3 au travers des évents de libération 32.

Les inventeurs ont ainsi mis en évidence que l'évacuation des produits de la réaction au travers des évents de libération 32 est possible et reste compatible, en termes de temps de gravure et d'élimination, avec les impératifs propres à une mise en oeuvre industrielle.

Ainsi, la couche métallique getter 40 est libérée, c'est-à-dire qu'elle présente au moins une partie de sa surface non recouverte par une autre couche, et donc exposée à l'atmosphère de la cavité 3.

En référence à la figure 2H, on dépose une couche de scellement 34 sur la couche d'encapsulation 31 avec une épaisseur suffisante pour assurer le scellement, ou bouchage, des évents de libération 32. La couche de scellement 34 est transparente au rayonnement électromagnétique à détecter et peut présenter une fonction d'antireflet pour optimiser la transmission du rayonnement au travers de la structure d'encapsulation 30. A ce titre, elle peut être formée de sous-couches de germanium et de sulfure de zinc dans le cas d'un rayonnement à détecter dans la gamme des longueurs d'onde allant de 8µm à 12µm, par exemple une première sous-couche de germanium de 1,7µm environ puis une deuxième sous-couche de sulfure de zinc de 1,2µm environ. La couche de scellement 34 est de préférence déposée par une technique de dépôt de couches minces sous vide, comme l'évaporation sous vide d'une source chauffée par faisceau d'électrons (EBPVD) ou comme la pulvérisation, cathodique ou par faisceau d'ions. On obtient ainsi une cavité hermétique 3 sous vide ou pression réduite dans laquelle sont logés le ou les détecteurs thermiques 10.

On active en outre la chimisorption de la couche métallique getter 40 en soumettant le dispositif de détection 1 à un traitement thermique adéquat, dans un four ou une étuve, de manière à faire réagir le matériau getter avec des molécules de gaz résiduelles présentes dans la cavité hermétique 3 et former ainsi des composés chimiques stables. On obtient ainsi un niveau de vide maintenu ou abaissé à l'intérieur de la cavité hermétique 3, améliorant ainsi la durée de vie du dispositif de détection 1.

Ainsi, par le dépôt d'une couche métallique getter 40 sur le substrat 2, et sa protection par une couche sacrificielle carbonée 50 vis-à-vis de la gravure chimique mise en oeuvre lors de l'étape de suppression des couches sacrificielles minérales 60A, 60B, on obtient un dispositif de détection 1 comportant une couche métallique getter 40 située sur le substrat 2 et préservée de toute dégradation. On améliore ainsi la durée de vie du dispositif de détection 1 réalisé en utilisant au moins une couche sacrificielle minérale 60A, 60B.

De plus, dans le cas où la couche métallique getter 40 est située sous la membrane absorbante 11, cette couche métallique getter 40 étant réflectrice aux longueurs d'onde à détecter, la sensibilité du détecteur thermique 10 est améliorée, d'autant que la couche métallique getter 40 n'est pas recouverte d'une autre couche, telle qu'une couche d'arrêt de gravure 4 comme dans l'exemple de l'art antérieur cité précédemment.

Par ailleurs, la couche métallique getter 40 peut également améliorer l'accroche de la structure d'encapsulation 30 sur le substrat 2 et/ou l'accroche et le contact électrique du pilier d'ancrage 12 avec la portion 21 de ligne métallique du circuit de lecture 20.

Des modes de réalisation particuliers viennent d'être décrits. Différentes variantes et modifications apparaîtront à l'homme du métier.

Ainsi, la figure 3 illustre une variante du procédé de réalisation du dispositif de détection 1 dans laquelle le dispositif de détection ne comporte pas de couche d'arrêt de gravure 4. La figure 3 correspond ici une variante de l'étape illustrée sur la figure 2E. La couche métallique getter 40 repose alors directement sur la surface supérieure du substrat 2, et la couche sacrificielle carbonée 50 s'étend de manière continue de manière à recouvrir la couche métallique getter 40 mais également la face supérieure du substrat 2. Elle assure donc une fonction d'arrêt de gravure vis-à-vis de la gravure chimique mise en oeuvre pour supprimer les couches sacrificielles minérales 60A, 60B, protégeant ainsi à la fois la couche métallique getter 40 mais également les couches diélectriques inter-métal 23 en matériau minéral présentes dans le substrat 2.

Dans cet exemple, la couche métallique getter 40 comporte une portion supplémentaire 43 qui repose sur la surface supérieure du substrat 2 et est disposée de manière à être en contact avec la première portion 21 de ligne métallique du circuit de lecture 20 d'une part, et à assurer l'accroche du pilier d'ancrage 12 d'autre part. On améliore ainsi la qualité du contact électrique entre le circuit de lecture 20 et le pilier d'ancrage 12, ainsi que l'accroche du pilier d'ancrage 12 sur le substrat 2.

Le procédé de réalisation se poursuit comme décrit précédemment avec la gravure chimique humide des couches sacrificielles minérales 60A, 60B (fig.2F), puis la gravure sèche par plasma d'oxygène de la couche sacrificielle carbonée 50 (fig.2G), ce qui met à nu les zones de la face supérieure du substrat 2 non recouvertes par les portions 41, 42, 43 de la couche métallique getter 40. La couche de scellement 34 est enfin déposée sur la couche d'encapsulation 31 de manière à obturer les évents de libération 32 (fig.2H).

Par ailleurs, la figure 4 illustre un autre mode de réalisation du dispositif de détection 1 qui diffère de celui illustré sur la figure 2H essentiellement en ce que la structure d'encapsulation 30 ne comporte pas une couche d'encapsulation 31 déposée par des techniques de dépôt en couche mince, mais un capot rigide rapporté, c'est-à-dire préalablement réalisé puis assemblé au substrat 2 de manière à encapsuler un ou plusieurs détecteurs thermiques 10. Le capot peut être réalisé à partir d'un substrat 2 en silicium et est structuré de manière à comporter une paroi périphérique 33 destinée à être assemblée au substrat 2. La paroi périphérique 33 est fixée au substrat 2 par l'intermédiaire d'un joint hermétique 35, ce dernier étant de préférence au contact d'une portion 42 d'accroche de la couche métallique getter 40. Le joint hermétique 35 peut être obtenu par la refonte d'un métal fusible ou par la formation d'un alliage intermétallique.

Le procédé de réalisation de ce mode de réalisation diffère ici de celui décrit en référence aux figures 2A à 2H en ce que, à la suite du dépôt de la première couche sacrificielle minérale 60A et de la réalisation du pilier d'ancrage 12, du bras d'isolation thermique 13, de la membrane absorbante 11 et du dépôt de la deuxième couche sacrificielle minérale 60B, on dépose, dans une tranchée réalisée par une gravure localisée des couches sacrificielles minérales 60a, 60B et de la couche sacrificielle carbonée 50, un matériau de scellement destiné à former le joint hermétique 35. Puis on supprime par gravure les couches sacrificielles minérales 60A, 60B puis la couche sacrificielle carbonée 50. On assemble ensuite le capot sur le substrat 2.

D'autres variantes sont possibles, telles que l'encapsulation du dispositif de détection 1 dans un boîtier logeant ensemble le ou les détecteurs thermiques 10 et le substrat 2. Le boîtier, réalisé par exemple en matériaux métalliques ou en matériaux céramiques, comporte alors une fenêtre transparente aux longueurs d'onde à détecter et située en regard du ou des détecteurs thermiques 10.

## Revendications

1. Procédé de réalisation d'un dispositif de détection (1) de rayonnement électromagnétique comprenant au moins un détecteur thermique (10), celui-ci comportant une membrane absorbante (11) adaptée à absorber le rayonnement à détecter, suspendue au-dessus d'un substrat (2), le détecteur thermique étant destiné à être situé dans une cavité hermétique (3), le procédé comportant au moins les étapes suivantes :
- dépôt, sur le substrat (2), d'une couche métallique dite getter (40) comprenant un matériau métallique à effet getter ;
- dépôt, de manière à recouvrir la couche métallique getter (40), d'une couche sacrificielle dite carbonée (50) comprenant un matériau carboné en carbone amorphe apte à être gravé sélectivement vis-à-vis de la couche métallique getter (40) par une seconde gravure chimique ;
- dépôt, sur la couche sacrificielle carbonée (50), d'au moins une couche sacrificielle minérale (60A, 60B) comprenant un matériau minéral apte à être gravé sélectivement vis-à-vis de la couche sacrificielle carbonée (50) par une première gravure chimique ;
- réalisation d'orifices verticaux traversant la couche sacrificielle minérale (60A) ainsi que la couche sacrificielle carbonée (50), destinés à la formation de piliers d'ancrage (12) du détecteur thermique (10), et réalisation des piliers d'ancrage (12) par remplissage des orifices par un ou plusieurs matériaux électriquement conducteurs ;
- aplanissement mécano-chimique de la couche sacrificielle minérale (60A) permettant de planariser une surface formée par la couche sacrificielle minérale (60A) et par les piliers d'ancrage (12) ;
- réalisation du détecteur thermique (10) de sorte que la membrane absorbante (11) est réalisée sur la couche sacrificielle minérale (60A) ;
- suppression de la couche sacrificielle minérale (60A, 60B) par ladite première gravure chimique ;
- suppression de la couche sacrificielle carbonée (50) par ladite seconde gravure chimique.

2. Procédé selon la revendication 1, dans lequel le matériau métallique à effet getter est choisi parmi le titane, le zirconium, le vanadium, le chrome, le cobalt, le fer, le manganèse, le palladium, le baryum, et/ou l'aluminium.

3. Procédé selon l'une quelconque des revendications 1 à 2, dans lequel le matériau minéral est un matériau comportant au moins de l'oxyde de silicium ou du nitrure de silicium.

4. Procédé selon l'une quelconque des revendications 1 à 3, dans lequel la première gravure chimique est une attaque chimique en milieu acide, de préférence à l'acide fluorhydrique en phase vapeur.

5. Procédé selon l'une quelconque des revendications 1 à 4, dans lequel la seconde gravure chimique est une gravure sèche par plasma d'oxygène.

6. Procédé selon l'une quelconque des revendications 1 à 5, dans lequel la couche métallique getter (40) repose et est au contact d'une couche électriquement isolante (23) du substrat (2), ou repose et est au contact d'une couche d'arrêt de gravure (4) réalisée en un matériau apte à stopper la première gravure chimique et recouvrant une face supérieure du substrat (2).

7. Procédé selon l'une quelconque des revendications 1 à 6, dans lequel la couche sacrificielle carbonée (50) recouvre la couche métallique getter (40).

8. Procédé selon l'une quelconque des revendications 1 à 7, dans lequel la couche métallique getter (40) comporte plusieurs portions distinctes (41, 42), dont au moins une première portion (41) est située sous la membrane absorbante (11).

9. Procédé selon l'une quelconque des revendications 1 à 8, dans lequel l'étape de réalisation du détecteur thermique (10) comporte la formation d'une structure d'encapsulation (30) dudit détecteur thermique, la structure d'encapsulation (30) comportant une couche d'encapsulation (31) s'étendant autour et au-dessus dudit détecteur thermique (10) de manière à définir avec le substrat (2) la cavité hermétique (3) dans laquelle ledit détecteur thermique (10) est situé, la couche d'encapsulation (31) comprenant au moins un orifice traversant (32), dit évent de libération ; et dans lequel des matériaux supprimés lors des première et deuxième gravures chimiques sont évacués au travers dudit évent de libération (32).

10. Procédé selon la revendication 9, dans lequel la couche d'encapsulation (31) est formée en au moins un matériau comportant du silicium.

11. Procédé selon la revendication 9 ou 10, dans lequel la couche d'encapsulation (31) comporte une paroi périphérique (33) qui s'étend autour dudit détecteur thermique (10), et qui est au contact de la couche métallique getter (40).

12. Procédé selon l'une quelconque des revendications 1 à 11, dans lequel le détecteur thermique (10) comporte au moins un pilier d'ancrage (12) assurant le maintien de la membrane absorbante (11) au-dessus du substrat (2), le pilier d'ancrage (12) étant au contact de la couche métallique getter (40).

## Patentansprüche

1. Verfahren zur Herstellung einer Vorrichtung zur Erfassung (1) von elektromagnetischer Strahlung, umfassend mindestens einen thermischen Detektor (10), wobei dieser eine Absorptionsmembran (11), die geeignet ist, die zu erfassende Strahlung zu absorbieren, die über einem Substrat (2) aufgehängt ist, aufweist, wobei der thermische Detektor dazu bestimmt ist, in einem hermetisch abgedichteten Hohlraum (3) angeordnet zu sein, wobei das Verfahren mindestens die folgenden Schritte aufweist:
- Abscheiden einer sogenannten Gettermetallschicht (40) auf dem Substrat (2), die ein metallisches Material mit Gettereffekt umfasst,
- Abscheiden einer sogenannten kohlenstoffhaltigen Opferschicht (50), die ein kohlenstoffhaltiges Material aus amorphem Kohlenstoff umfasst, das geeignet ist, selektiv bezüglich der Gettermetallschicht (40) durch ein zweites chemisches Ätzen geätzt zu werden, derart, um die die Gettermetallschicht (40) abzudecken,
- Abscheiden von mindestens einer mineralischen Opferschicht (60A, 60B), die ein mineralisches Material umfasst, das geeignet ist, selektiv bezüglich der kohlenstoffhaltigen Opferschicht (50) durch ein erstes chemisches Ätzen geätzt zu werden, auf der kohlenstoffhaltigen Opferschicht (50),
- Erzeugen vertikaler Öffnungen, die die mineralische Opferschicht (60A) und die kohlenstoffhaltige Opferschicht (50) durchqueren, die zum Bilden von Ankerstützen (12) des thermischen Detektors (10) bestimmt sind, und Herstellen der Ankerstützen (12) durch Füllen der Öffnungen mit einem oder mehreren elektrisch leitfähigen Materialien,
- mechanisch-chemisches Planieren der mineralischen Opferschicht (60A), das ermöglicht, eine Oberfläche zu planieren, die durch die mineralische Opferschicht (60A) und durch die Ankerstützen (12) gebildet ist,
- Erstellen des thermischen Detektors (10), derart, dass die Absorptionsmembran (11) auf der mineralischen Opferschicht (60A) erstellt wird,
- Entfernen der mineralischen Opferschicht (60A, 60B) durch das erste chemische Ätzen,
- Entfernen der kohlenstoffhaltigen Opferschicht (50) durch das zweite chemische Ätzen.

2. Verfahren nach Anspruch 1, wobei das metallische Material mit Gettereffekt aus Titan, Zirkonium, Vanadium, Chrom, Cobalt, Eisen, Mangan, Palladium, Barium und/oder Aluminium ausgewählt wird.

3. Verfahren nach einem der Ansprüche 1 bis 2, wobei das mineralische Material ein Material ist, das mindestens Siliciumoxid oder Siliciumnitrid umfasst.

4. Verfahren nach einem der Ansprüche 1 bis 3, wobei das erste chemische Ätzen ein chemischer Angriff in saurem Medium, vorzugsweise mit Flusssäure in Dampfphase, ist.

5. Verfahren nach einem der Ansprüche 1 bis 4, wobei das zweite chemische Ätzen ein Trockenätzen mit Sauerstoffplasma ist.

6. Verfahren nach einem der Ansprüche 1 bis 5, wobei die Gettermetallschicht (40) auf einer elektrisch isolierenden Schicht (23) des Substrats (2) aufliegt und mit dieser in Kontakt ist oder auf einer Ätzstoppschicht (4) aufliegt und mit dieser in Kontakt ist, die aus einem Material erstellt ist, das geeignet ist, das erste chemische Ätzen zu stoppen, und eine Oberseite des Substrats (2) bedeckt.

7. Verfahren nach einem der Ansprüche 1 bis 6, wobei die kohlenstoffhaltige Opferschicht (50) die Gettermetallschicht (40) bedeckt.

8. Verfahren nach einem der Ansprüche 1 bis 7, wobei die Gettermetallschicht (40) mehrere verschiedene Abschnitte (41, 42) aufweist, wovon mindestens ein erster Abschnitt (41) unter der Absorptionsmembran (11) angeordnet ist.

9. Verfahren nach einem der Ansprüche 1 bis 8, wobei der Schritt des Erstellens des thermischen Detektors (10) das Bilden einer Einkapselungsstruktur (30) des thermischen Detektors aufweist, wobei die Einkapselungsstruktur (30) eine Einkapselungsschicht (31) aufweist, die sich um und über dem thermischen Detektor (10) derart erstreckt, um mit dem Substrat (2) den hermetisch abgedichteten Hohlraum (3) zu definieren, in dem der thermische Detektor (10) angeordnet ist, wobei die Einkapselungsschicht (31) mindestens eine Durchgangsöffnung (32) aufweist, die Freisetzungsöffnung genannt wird, und wobei die Materialien, die während des ersten und des zweiten chemischen Ätzens entfernt werden, durch die Freigabeöffnung (32) abgegeben werden.

10. Verfahren nach Anspruch 9, wobei die Einkapselungsschicht (31) aus mindestens einem Material gebildet wird, das Silizium umfasst.

11. Verfahren nach Anspruch 9 oder 10, wobei die Einkapselungsschicht (31) eine Umfangswand (33) aufweist, die sich um den thermischen Detektor (10) herum erstreckt und die mit der Gettermetallschicht (40) in Kontakt ist.

12. Verfahren nach einem der Ansprüche 1 bis 11, wobei der thermische Detektor (10) mindestens eine Ankerstütze (12) aufweist, die das Halten der Absorptionsmembran (11) über dem Substrat (2) gewährleistet, wobei die Ankerstütze (12) in Kontakt mit der Gettermetallschicht (40) ist.

## Claims

1. Method for making an electromagnetic radiation detecting device (1) comprising at least one thermal detector (10), the latter comprising an absorbent membrane (11) suitable for absorbing the radiation to be detected, suspended above a substrate (2), the thermal detector being intended to be located in a sealed cavity (3), said method comprising at least the following steps:
- depositing, on the substrate (2), a so-called gettering metallic layer (40) comprising a metallic material with a gettering effect;
- depositing, so as to cover the gettering metallic layer (40), a so-called carbonaceous sacrificial layer (50) comprising a carbonaceous material of amorphous carbon that can be etched selectively with respect to the gettering metallic layer (40) by a second chemical etching;
- depositing, on the carbonaceous sacrificial layer (50), at least one sacrificial mineral layer (60A, 60B) comprising a mineral material that can be etched selectively with respect to the carbonaceous sacrificial layer (50) by a first chemical etching;
- production of vertical holes passing through the sacrificial mineral layer (60A) as well as the carbonaceous sacrificial layer (50), which are intended for forming anchoring pillars (12) of the thermal detector (10), and production of the anchoring pillars (12) by filling the holes with one or more electrically conducting materials;
- chemical-mechanical planarization of the sacrificial mineral layer (60A) providing planarization of a surface formed by the sacrificial mineral layer (60A) and the anchoring pillars (12);
- fabricating the thermal detector (10) so that the absorbent membrane (11) is produced on the sacrificial mineral layer (60A);
- removing the sacrificial mineral layer (60A, 60B) by said first chemical etching;
- removing the carbonaceous sacrificial layer (50) by said second chemical etching.

2. Method according to Claim 1, wherein the metallic material with a gettering effect is selected from titanium, zirconium, vanadium, chromium, cobalt, iron, manganese, palladium, barium, and/or aluminium.

3. Method according to either one of Claims 1 and 2, wherein the mineral material is a material comprising at least silicon oxide or silicon nitride.

4. Method according to any one of Claims 1 to 3, wherein the first chemical etching is chemical attack in an acid medium, preferably with hydrofluoric acid in the vapour phase.

5. Method according to any one of Claims 1 to 4, wherein the second chemical etching is dry etching by oxygen plasma.

6. Method according to any one of Claims 1 to 5, wherein the gettering metallic layer (40) rests on and is in contact with an electrically insulating layer (23) of the substrate (2), or rests on and is in contact with an etching barrier layer (4) made of a material that is able to stop the first chemical etching and that covers an upper face of the substrate (2).

7. Method according to any one of Claims 1 to 6, wherein the carbonaceous sacrificial layer (50) covers the gettering metallic layer (40).

8. Method according to any one of Claims 1 to 7, wherein the gettering metallic layer (40) comprises several separate portions (41, 42), of which at least a first portion (41) is located under the absorbent membrane (11).

9. Method according to any one of Claims 1 to 8, wherein the step of fabricating the thermal detector (10) comprises the formation of an encapsulating structure (30) of said thermal detector, the encapsulating structure (30) comprising an encapsulating layer (31) extending around and above said thermal detector (10) so as to define, with the substrate (2), the sealed cavity (3) in which said thermal detector (10) is located, the encapsulating layer (31) comprising at least one through hole (32), called a release vent; and in which materials removed during the first and second chemical etchings are evacuated through said release vent (32).

10. Method according to Claim 9, wherein the encapsulating layer (31) is formed of at least one material comprising silicon.

11. Method according to Claim 9 or 10, wherein the encapsulating layer (31) comprises a peripheral wall (33) that extends around said thermal detector (10), and is in contact with the gettering metallic layer (40).

12. Method according to any one of Claims 1 to 11, wherein the thermal detector (10) comprises at least one anchoring pillar (12) for holding the absorbent membrane (11) in place above the substrate (2), the anchoring pillar (12) being in contact with the gettering metallic layer (40).
